# EUROPEAN PATENT APPLICATION

(11) **EP 4 819 796 A1**
(43) Date of publication of application: **07.10.2026**
(21) Application number: 26152039.9
(22) Date of filing: 15.01.2026
(51) Int. Cl.: H10F 10/165, H10F 71/00, H10F 77/14, H10F 77/20, H10F 77/30

(54) **SOLAR CELL, METHOD FOR MANUFACTURING THEREOF, AND PHOTOVOLTAIC MODULE**

(30) Priority: 31.03.2025 CN 202510397299
(71) Applicant: Tongwei Solar (Chengdu) Co., Ltd., Chengdu, Sichuan 610299 (CN)
(72) Inventor: LYU, Aiwu, Chengdu, 610299 (CN); YU, Bin, Chengdu, 610299 (CN); MENG, Xiajie, Chengdu, 610299 (CN)
(74) Representative: Dehns Germany Partnerschaft mbB

(57) **Abstract**

The present invention relates to the field of solar cells, and in particular, to a solar cell, a method for manufacturing thereof, and a photovoltaic module. The solar cell includes: a substrate; a doped layer which is patterned; grid lines including busbar electrodes, finger electrodes and auxiliary electrodes; and pads; where the doped layer includes a first film portion disposed opposite to the busbar electrodes and the finger electrodes in a thickness direction of the substrate; the doped layer further includes at least one second film portion; and in the thickness direction of the substrate, an orthographic projection of the pads on the substrate is contained in a range of an orthographic projection of the at least one second film portion on the substrate.

## Description

### Technical Field

The present invention relates to the technical field of solar cells, and in particular, to a solar cell, a method for manufacturing thereof, and a photovoltaic module.

### Background

The conversion efficiency of a light-receiving surface of a solar cell often receives more attention, while the conversion efficiency of a backlight surface is less emphasized due to the relatively lower light incidence on the backlight surface, coupled with the influence of films such as a back-side doped layer. However, improving the conversion efficiency of the backlight surface of the solar cell is crucial for increasing the bifaciality and power output of a photovoltaic module including solar cells, as well as for reducing the cost of photovoltaic power generation.

Current efforts to improve the conversion efficiency of the backlight surface usually lead to new problems when improving the light utilization capability of the backlight surface, for example, increasing the difficulty of manufacturing high-precision electrodes on the back-side doped layer, thus affecting the carrier transport capability of the back-side doped layer. Therefore, how to improve the conversion efficiency of the backlight surface of the solar cell and increase the bifaciality while minimizing the impact on the carrier transport capability of the backlight surface and reducing the difficulty of electrode manufacturing are urgent problems to be solved.

### Summary

In order to solve the above technical problems, the present invention discloses a solar cell, a method for manufacturing thereof, and a photovoltaic module, such that the photoelectric conversion efficiency and bifaciality of the solar cell and photovoltaic module are improved while the difficulty of electrode manufacturing is reduced.

In a first aspect, the present invention provides a solar cell, and the solar cell includes: a substrate; a doped layer which is patterned, disposed on a backlight surface of the substrate; grid lines, disposed on a side of the doped layer away from the substrate, where the grid lines include busbar electrodes and finger electrodes, which are intersected with each other, as well as auxiliary electrodes, and the auxiliary electrodes are connected to end portions of the busbar electrodes in a length extending direction in a one-to-one manner; and pads, disposed on the busbar electrodes and at junctions between the busbar electrodes and the auxiliary electrodes, where the doped layer includes a first film portion disposed opposite to the busbar electrodes and the finger electrodes in a thickness direction of the substrate; the doped layer further includes at least one second film portion disposed opposite to the pads in the thickness direction of the substrate; and in the thickness direction of the substrate, an orthographic projection of the pads on the substrate is contained in a range of an orthographic projection of the at least one second film portion on the substrate.

In some embodiments, a plurality of second film portions are provided, the pads and the plurality of second film portions satisfy at least one of following: the pads are disposed at intervals, and the pads are disposed corresponding to the plurality of second film portions in a one-to-one manner; the pads are disposed corresponding to the plurality of second film portions in a one-to-one manner, in any group of a pad and a second film portion correspondingly to each other, an area of the pad is S₁, and an area of the second film portion is S₂, where 0.1≤S₁:S₂<1; or, a spacing between each two adjacent busbar electrodes is greater than a spacing between each two adjacent finger electrodes, and busbar electrodes around the pads are disposed opposite to the at least one second film portions in the thickness direction of the substrate; or, the solar cell satisfies at least one of following: the auxiliary electrodes include at least one of a fork-shaped grid line, a wave-shaped grid line, or a cross-shaped grid line; the doped layer further includes third film portions disposed opposite to the auxiliary electrodes in the thickness direction of the substrate; and in the thickness direction of the substrate, an orthographic projection of the auxiliary electrodes on the substrate is contained in an orthographic projection of the third film portions on the substrate.

In some embodiments, the first film portion includes first sub-portions disposed opposite to the busbar electrodes in the thickness direction of the substrate, and second sub-portions disposed opposite to the finger electrodes; and each of the at least one second film portion is disposed between two second sub-portions, and at least one edge of each of the at least one second film portion in a length extending direction of each of the first sub-portions is attached to a corresponding second sub-portion.

In some embodiments, each of the at least one second film portion is disposed between two adjacent second sub-portions, or each of the at least one second film portion is disposed between two second sub-portions that are not adjacent to each other, and one or more second sub-portions are disposed between the two second sub-portions that are not adjacent to each other.

In some embodiments, each of the auxiliary electrodes is the fork-shaped grid line; each of the fork-shaped grid lines includes a first fork line and a second fork line, a length extending direction of the first fork line is intersected with a length extending direction of the second fork line; the first fork line and the second fork line are disposed at intervals in a length extending direction of each of the finger electrodes to form an interval region; and an orthographic projection of the fork-shaped grid lines on the substrate is contained in an orthographic projection of the third film portions on the substrate.

In some embodiments, the third film portions are also disposed opposite to positions of interval regions in the thickness direction of the substrate; or, the solar cell satisfies at least one of following: end portions of the busbar electrodes are disposed in interval regions; some of the finger electrodes are disposed in interval regions.

In some embodiments, the backlight surface includes a first region and a second region disposed outside the first region, and the first region is covered by the doped layer.

In some embodiments, the first region includes first sub-regions disposed opposite to the first film portion in the thickness direction of the substrate, and second sub-regions disposed opposite to the at least one second film portion in the thickness direction of the substrate; in the thickness direction of the substrate, an orthographic projection of the second sub-regions overlaps with an orthographic projection of the at least one second film portion on the substrate; or, a reflectivity of the solar cell in the first region of the backlight surface is R₁, a reflectivity of the solar cell in the second region of the backlight surface is R₂, and R₁ is different from R₂; or, on a side of the backlight surface, a first textured surface structure is disposed on a surface of the substrate in the first region, a second textured surface structure is disposed on a surface of the substrate in the second region, and the first textured surface structures and the second textured surface structures are different.

In some embodiments, in the thickness direction of the substrate, an orthographic projection of the first sub-regions overlaps with an orthographic projection of the first film portion on the substrate, and an orthographic projection of the grid lines on the substrate is contained in the orthographic projection of the first film portion on the substrate.

In some embodiments, the second textured surface structures include at least one of protruding structures or recessed structures; or, a recessed depth of a surface of the substrate in the second region relative to a surface of the substrate in the first region is h, and 0.1 µm < h < 7 µm; or, the first textured surface structure includes a plurality of boss structures, and the plurality of boss structures satisfies at least one of following: the plurality of boss structures are disposed at intervals, or a stacked crossover region exists between the plurality of boss structures; a side length of a bottom of each of the plurality of boss structures is 0.5 µm~8 µm, a side length of a top of each of the plurality of boss structures is 0.1 µm~5 µm, and a height of each of the plurality of boss structures is 0.1 µm~5 µm; a shape of a cross section of each of the plurality of boss structures is a rectangle, a rhombus, a trapezoid, or an irregular polygon.

In some embodiments, the protruding structures satisfies at least one of following: the protruding structures include at least one of upright pyramids, truncated pyramids, or curved protrusions; a micro-etched structure is disposed on an outer surface of each of the protruding structures; or, the recessed structures include at least one of dispersed pits, a pit island including a plurality of interconnected pits, or inverted pyramids; and the solar cell satisfies at least one of following: a depth of each of the recessed structures relative to a portion of the backlight surface in the second region is 0.2 µm~10.0 µm; a tilt angle of a side wall of the recessed structure relative to a portion of the backlight surface in the second region is θ, and 90° < θ < 170°; a maximum distance between any two points on an opening contour of each of the recessed structures is 2 µm~40 µm; a reflectivity of the solar cell in the second region of the backlight surface is 0.5%~25.0%.

In some embodiments, the protruding structures include the upright pyramids; the solar cell satisfies at least one of following: a side length of a base of each of the upright pyramids is 0.2 µm~3.5 µm; a micro-etched structure is disposed on an outer surface of each of the upright pyramids; a reflectivity of the solar cell in the second region of the backlight surface is 0.5%~8.0%, which is less than a reflectivity of the solar cell in the first region of the backlight surface; or, the protruding structures include the truncated pyramids, and the truncated pyramids include at least one of regular truncated pyramids or irregular truncated pyramids; the solar cell satisfies at least one of following: a side length of a base of each of the truncated pyramids is 0.2 µm~3.5 µm; a micro-etched structure is disposed on an outer surface of each of the truncated pyramids; a reflectivity of the solar cell in the second region of the backlight surface is 0.5%~20%, which is less than a reflectivity of the solar cell in the first region of the backlight surface; or, the protruding structures include the curved protrusions; the solar cell satisfies at least one of following: a height of each of the curved protrusions is less than1.5 µm; a reflectivity of the solar cell in the second region of the backlight surface is 0.5%~25.0%, which is less than a reflectivity of the solar cell in the first region of the backlight surface.

In a second aspect, embodiments of the present invention provide a method for manufacturing the solar cell as described in the first aspect. The method includes the following steps: patterning a doped layer disposed between a substrate and a mask layer and to form a first region and a second region outside the first region, which are different in pattern; etching a portion of the doped layer in the second region until a surface of the substrate in the second region is exposed; removing a remaining mask layer to expose a patterned doped layer, where the patterned doped layer includes a first film portion and at least one second film portion; and forming grid lines and pads on the patterned doped layer such that busbar electrodes and finger electrodes are disposed on the first film portion, the pads are disposed on the at least one second film portion, and in a thickness direction of the substrate, an orthographic projection of the pads on the substrate is contained in an orthographic projection of the at least one second film portion on the substrate.

In some embodiments, etching the portion of the doped layer in the second region includes: forming a second textured surface structure on a surface of the substrate in the second region by isotropic etching, anisotropic etching, or a combination of the isotropic etching and anisotropic etching; or, before patterning the doped layer disposed with the substrate and the mask layer, the method further includes performing pretreatment on the substrate; and performing the pretreatment on the substrate includes: forming emitters on a light-receiving surface of the substrate; etching a backlight surface of the substrate such that a first textured surface structure is formed on the backlight surface of the substrate; and forming the doped layer and the mask layer on the backlight surface of the substrate.

In a third aspect, embodiments of the present invention provide a photovoltaic module, including the solar cells as described in the first aspect, or any one of the solar cell manufactured by the method described in the second aspect.

Compared with the prior art, the present invention has at least the following beneficial effects.

The solar cell in the embodiments of the present invention can not only effectively reduce a current loss caused by parasitic absorption in the doped layer and improve the light utilization efficiency of the backlight surface, but also ensure the carrier transport capability of the backlight surface, reduce the difficulty of pad manufacturing, and avoid problems of over-firing, thereby improving the overall photoelectric conversion efficiency of the cell and the power generation utilization rate of the backlight surface. Through comprehensive improvements in the above aspects, the improvement of the overall efficiency and bifaciality of the solar cell is promoted, thereby increasing the power generation capability of a photovoltaic module using the solar cell, and reducing the cost of power generation.

In an aspect, the backlight surface of the substrate of the present invention uses the patterned doped layer; the doped layer includes the first film portion and the second film portion; the first film portion is correspondingly located under the busbar electrode and the finger electrode; and the second film portion is correspondingly located under the pad. Through such arrangement, the set area of the doped layer on the backlight surface can be decreased rationally to reduce parasitic absorption, such that the light utilization efficiency of the backlight surface is improved, thereby improving the conversion efficiency of the solar cell. The light shielding characteristics of the grid line and the pad can also be fully utilized, such that the set area of the doped layer located under the grid line and the pad is maximized, and it ensures that the doped layer can effectively serve as a carrier transport channel and provide a field passivation effect on the basis of reducing parasitic absorption. Therefore, the carrier transport performance can be ensured, and the light utilization efficiency of the backlight surface can also be improved.

In another aspect, based on this, through the arrangement in the present invention, the orthographic projection of the pad is located within the range of the orthographic projection located at the second film portion of the doped layer. Through such arrangement, first, alignment difficulty may be reduced by using the second film portion as an auxiliary alignment point for printing the grid line and the pad; and second, a tolerance degree for a pad printing deviation range can be increased.

Therefore, even if there is a deviation during pad printing, the pad is unlikely to exceed the second film portion as a certain region (the region between the orthographic projection of the pad and the orthographic projection of the second film portion) is reserved at the second film portion to accommodate the deviation, such that it may ensure that during pad manufacturing, the problems of metal-induced recombination and the like caused by excessive sintering of a slurry are prevented.

### Brief Description of the Drawings

In order to describe the technical solutions in embodiments of the present invention more clearly, the drawings required to be used in the embodiments will be simply introduced below. It is apparent that the drawings in the following descriptions are only some embodiments of the present invention. Those of ordinary skill in the art may further obtain other drawings according to these drawings without creative work.
Fig. 1 is a cross-sectional view of a solar cell according to an embodiment of the present invention.
Fig. 2 is a bottom view of a solar cell according to an embodiment of the present invention.
Fig. 3 is a schematic enlarged view of region A in Fig. 2.
Fig. 4 is a schematic diagram of a position correspondence relationship between grid lines and pads, a doped layer, and a substrate in Fig. 3.
Fig. 5 is a schematic diagram of different deformation shapes of a second film portion of a doped layer in a solar cell according to an embodiment of the present invention.
Fig. 6 is a partial schematic diagram of a solar cell according to another embodiment of the present invention.
Fig. 7 is a schematic enlarged view of region B in Fig. 2.
Fig. 8 to Fig. 11 are schematic structural diagrams of a protruding structure disclosed according to different embodiments of the present invention.
Fig. 12 is a schematic structural diagram of a recessed structure disclosed according to an embodiment of the present invention.

In the drawings:
1A, First region; 1A1, First sub-region; 1A2, Second sub-region; 1B, Second region; 100, Substrate; 110, Protruding structure; 120, Recessed structure; 121, Side wall; 121a, First side line; 122, Bottom wall; 122a, Second side line; 200, Doped layer; 210, First film portion; 211, First sub-portion; 212, Second sub-portion; 220, Second film portion; 300, Grid line; 310, Busbar electrode; 320, Finger electrode; 330, Auxiliary electrode; 331, First fork line; 332, Second fork line; 330a, Interval region; 400, Pad; 500, Back-side passivation and anti-reflection layer; 600, Back-side dielectric layer; 700, Front-side doped layer; 800, Front-side passivation anti-reflection layer; and 900, Front-side grid line.

### Detailed Description of the Embodiments

The technical solutions in the embodiments of the present invention will be clearly and completely described below in combination with the drawings in the embodiments of the present invention. It is apparent that the described embodiments are only part of the embodiments of the present invention, not all the embodiments. All other embodiments obtained by those of ordinary skill in the art on the basis of the embodiments in the present invention without creative work fall within the scope of protection of the present invention.

In the present invention, orientation or position relationships indicated by terms "upper", "lower", "left", "right", "front", "back", "top", "bottom", "inside", "outside", "vertical", "horizontal", "transverse", "longitudinal" and the like are orientation or position relationships shown in the drawings.

These terms are mainly used to better describe the present invention and its embodiments, rather than limit that the indicated devices, components and constituting parts must be in specific orientations or structured and operated in the specific orientations. Furthermore, the above mentioned part of terms may be not only used to represent the orientation or position relationships, but used to represent other meanings, for example, term "on" may be used to represent certain relationship of dependence or connection relationship in some cases. For those of ordinary skill in the art, specific meanings of these terms in the present invention may be understood according to a specific condition. In addition, terms "mount", "configure", "provide", "connect", and "link" should be broadly understood. For example, the term "connect" may be fixed connection, detachable connection or integral construction. As an alternative, the term "connect" may be mechanical connection, or electrical connection. As an alternative, the term "connect" may be direct connection, or indirect connection through a medium, or communication in two devices, components or constituting parts. For those of ordinary skill in the art, specific meanings of the above mentioned terms in the present invention may be understood according to a specific condition. Furthermore, the terms "first", "second" are primarily used to distinguish different apparatuses, elements, or components (which may or may not be identical in specific type and construction), and are not intended to indicate or imply the relative importance or number of the apparatuses, elements, or components being referred to. Unless otherwise stated, "a plurality of" means two or more.

People often focus solely on the conversion efficiency of a light-receiving surface of a solar cell while neglecting the efficiency of a backlight surface of the solar cell. Although most of light is incident on and utilized by the light-receiving surface of the solar cell, in reality, a portion of light also enter from the backlight surface of the solar cell.

The applicant believes that although the conversion efficiency of the backlight surface of the solar cell is currently not prioritized, improving the conversion efficiency of the backlight surface of the solar cell has significant importance. This is because, once the conversion efficiency of the backlight surface of a single solar cell is improved to a certain extent, the effect of improving the conversion efficiency can be amplified in a photovoltaic system including a plurality of solar cells, thereby increasing the bifaciality, and reducing the cost of photovoltaic power generation.

However, due to the significant parasitic absorption of light by a doped layer (for example, a doped crystalline silicon layer) on the backlight surface of the solar cell, the light absorption capability of the backlight surface is affected, thus affecting the conversion efficiency of the backlight surface. Although parasitic absorption can be reduced by decreasing the coverage area of the doped layer on the backlight surface of the solar cell, this can affect the carrier transport capability of the backlight surface. Moreover, if the coverage area of the doped layer on the backlight surface is smaller, the precision required for manufacturing pads on the doped layer is higher. Misalignment in pad manufacturing above the doped layer easily leads to over-firing of the pad slurry during sintering, resulting in a series of problems of metal-induced recombination. Therefore, improving the conversion efficiency of the backlight surface of the solar cell is not an easy task, factors such as the above parasitic absorption, carrier transport capability, pad alignment accuracy need to be comprehensively taken into consideration.

Based on the above analysis, embodiments of the present invention provide a solar cell and a method for manufacturing thereof, and a photovoltaic module, such that the conversion efficiency of the backlight surface of the solar cell is improved, the carrier transport capability of the backlight surface is ensured, the difficulty of pad manufacturing is reduced, and the problem of metal-induced recombination caused by slurry sintering is solved.

In a first aspect, an embodiment of the present invention provides a solar cell.

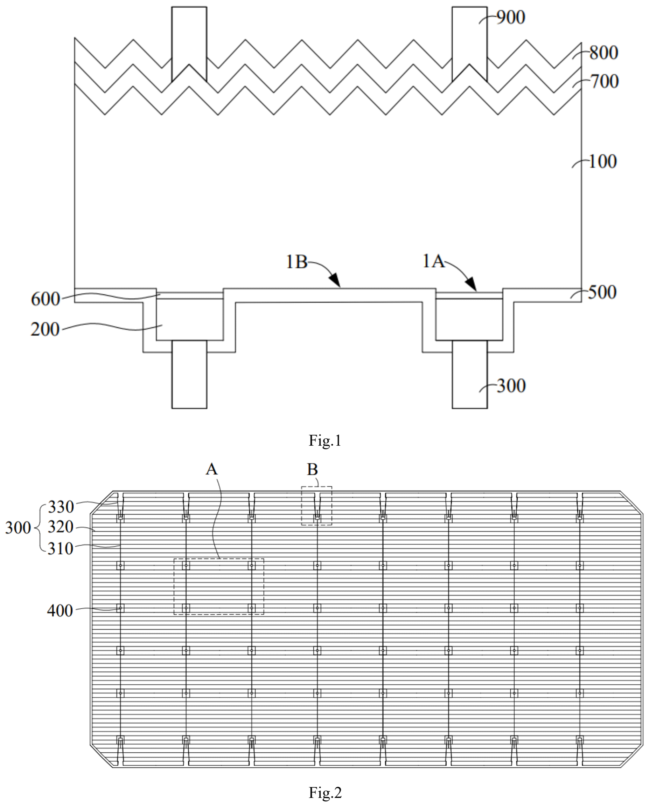

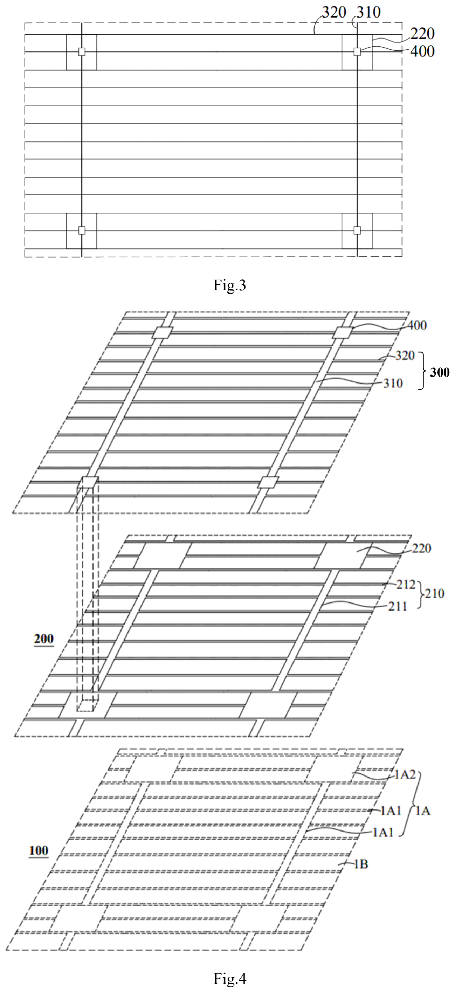

Referring to Fig. 1 to Fig. 4, Fig. 1 and Fig. 2 respectively show the solar cell from a cross-sectional view and a bottom view. The bottom view of the solar cell in Fig. 2 is an orthographic view of the solar cell observed from the back side of the solar cell. Fig. 3 is a schematic enlarged view of region A in Fig. 2. Fig. 4 shows a position correspondence relationship between the grid lines, the pads, the doped layer, and the substrate in Fig. 3. Moreover, in order to conveniently show the correspondence relationship, other films that can be disposed between the grid lines and the pads and the doped layer are omitted in Fig. 4. It can be understood that, films such as a back-side passivation and anti-reflection layer can also be disposed above the doped layer and under the grid lines and the pads, which does not affect the position correspondence relationship between the above structures. Furthermore, a parallelogram dashed box inside a second film portion of the doped layer in Fig. 4 merely shows a projection contour range of a pad on the second film portion, and a dashed line region of the substrate in Fig. 4 merely shows a first region and second regions.

The solar cell in the embodiments of the present invention includes a substrate 100, a doped layer 200 which is patterned, grid lines 300 and pads 400.

The doped layer 200 is disposed on a backlight surface of the substrate 100.

The grid lines 300 are disposed on the side of the doped layer 200 away from the substrate 100. The grid line 300 includes busbar electrodes 310 and finger electrodes 320, which are intersected with each other, as well as auxiliary electrodes 330. The auxiliary electrodes 330 are disposed close to end portions of the busbar electrodes 310 in a length extending direction, and the auxiliary electrodes are connected to end portions of the busbar electrodes in a length extending direction in a one-to-one manner.

The pads 400 are disposed on the busbar electrodes 310 and at junctions between the busbar electrodes 310 and the auxiliary electrodes 330.

The doped layer 200 includes a first film portion 210 disposed corresponding to positions of the busbar electrodes 310 and finger electrodes 320; the doped layer 200 further includes second film portions 220 disposed corresponding to positions of the pads 400; and in the thickness direction of the substrate 100, an orthographic projection of the pads 400 on the substrate 100 is contained in a range of an orthographic projection of the second film portions 220 on the substrate 100.

The substrate 100 can be a silicon substrate, a perovskite substrate, a Copper Indium Gallium Selenide (CIGS) substrate, or a gallium arsenide (GaAs) substrate, and the type of the substrate 100 is not limited in the present invention. In some embodiments, the substrate is the silicon substrate.

The doped layer 200 can be a doped conductive layer with a certain doped concentration on a back side of the solar cell, so as to establish a built-in electric field to prevent minority carriers from diffusing to the back side, thereby allowing majority carriers to transmit to grid lines on the backlight surface and be collected. Furthermore, the doped layer 200 is of a patterned structure. That is to say, the doped layer 200 does not completely cover the backlight surface of the substrate 100, and a portion of the backlight surface of the substrate 100 is not covered by the doped layer 200. Exemplarily, the doped layer 200 can be a polycrystalline silicon doped layer, an amorphous silicon doped layer, or a microcrystalline silicon doped layer, and a type of the doped layer 200 is not limited in the present invention. The conductivity type of the substrate 100 and that of the doped layer 200 are the same or different.

The grid lines 300 can collect photogenerated carriers generated on the back side of the cell, and transmit them into an external circuit, thereby realizing effective output of electrical energy. Exemplarily, the grid lines 300 can be made of a material of silver, copper, aluminum, nickel or alloy thereof. For example, the material of the grid lines 300 can include at least one of silver, silver alloy, silver-coated copper, copper, copper alloy, aluminum, aluminum alloy, nickel, or nickel alloy. The material of the grid lines 300 is not limited in the present invention. In the grid line 300, the finger electrodes 320 are configured to collect carriers from the substrate 100; the busbar electrodes 310 is configured to further gather the carriers collected by the finger electrodes 320; and the auxiliary electrodes 330 are connected to end portions of the busbar electrodes 310 in a length extending direction, and can cooperate with ribbons to connect different solar cells, so as to form a photovoltaic module in parallel, in series, or in a combination thereof. The busbar electrodes 310 intersects with the finger electrodes 320, and an included angle between a busbar electrode intersects a finger electrode can be a right angle, an acute angle, or an obtuse angle. The shape of each of the busbar electrodes 310 and the shape of each of the finger electrodes 320 can both be strip-shaped or zigzag-shaped. The shapes of the busbar electrodes 310 and the finger electrodes 320 are not limited in the present invention.

The pads 400 are disposed on the busbar electrodes 310 and at junctions between the busbar electrodes 310 and the auxiliary electrodes 330. The pads 400 are configured to weld ribbons, and connect a plurality of solar cells in series or in parallel to form a photovoltaic module. The pads 400 can be made of a material of silver, copper, aluminum, nickel or alloy thereof. For example, the material of the pads 400 can include at least one of silver, silver alloy, silver-coated copper, copper, copper alloy, aluminum, aluminum alloy, nickel, or nickel alloy. The material of the pads 400 is not limited in the present invention. The silver-coated copper refers to a metal composite material with the periphery of copper being coated with silver.

Referring to Fig. **4****,** the doped layer 200 includes the first film portion 210 corresponding to the positions of the busbar electrodes 310 and the finger electrodes 320, and the second film portions 220 disposed corresponding to the position of the pads 400. That is to say, the first film portion 210 and the second film portions 220 are different portions of the doped layer 200 that are respectively disposed under the grid lines 300 and the pads 400. When there is only one doped layer 200, the doped layer 200 includes the first film portion 210 and the second film portions 220; and when there are a plurality of doped layers 200, at least one of the plurality of doped layers 200 includes the first film portion 210 and the second film portions 220. The present invention is not limited thereto. Furthermore, it is to be noted that, the above corresponding disposal means that, in the thickness direction of the substrate 100, the first film portion 210 is disposed opposite to the finger electrodes and the busbar electrodes, and the second film portions 220 are disposed opposite to the pads 400.

In the thickness direction of the substrate 100 (a direction perpendicular to a paper surface in Fig. 2), the orthographic projection of the pads 400 on the substrate 100 is contained in the range of the orthographic projection of the second film portions 220 on the substrate 100, that is to say, the orthographic projection of the pads 400 on the substrate 100 is completely covered by the orthographic projection of the second film portions 220 on the substrate 100, and there is a spacing between the orthographic projection of the pads 400 on the substrate 100 and the orthographic projection of the second film portions 220 on the substrate 100. In other words, in a direction perpendicular to the thickness direction of the substrate 100, an outer contour of the second film portion 220 exceeds an outer contour of the pad 400 corresponding to each other.

In the embodiments of the present invention, through the above disposal, on the basis of ensuring carrier transport performance, the light utilization efficiency of the backlight surface can be improved, and the difficulty of grid line manufacturing can also be reduced, thereby reducing the problems such as over-firing and metal-induced recombination during grid line manufacturing, which otherwise degrade the photovoltaic conversion efficiency.

In an aspect, the patterned doped layer 200 are disposed on the backlight surface of the substrate 100 of the present invention; the doped layer 200 includes the first film portion 210 and the second film portions 220; the first film portion 210 is correspondingly disposed under the busbar electrodes 310 and the finger electrodes 320; and the second film portions 220 are correspondingly disposed under the pads 400. Through such disposal, the area of the doped layer 200 on the backlight surface can be decreased rationally to reduce parasitic absorption, such that the light utilization efficiency of the backlight surface is improved, thereby improving the conversion efficiency of the backlight surface of the solar cell. The light shielding characteristics of the grid lines 300 and the pads 400 can also be fully utilized, such that the area of the doped layer disposed under the grid lines and the pads is maximized, and it ensures that the doped layer 200 can effectively serve as a carrier transport channel and provide a field passivation effect on the basis of reducing parasitic absorption. Therefore, the carrier transport performance can be ensured, and the light utilization efficiency of the backlight surface can also be improved.

In another aspect, based on this, the orthographic projection of the pads 400 is contained in the range of the orthographic projection disposed at the second film portions 220 of the doped layer 200. Through such disposal, firstly, alignment difficulty can be reduced by regarding the second film portions 220 as auxiliary alignment points for printing the grid lines 300 and the pads 400; and secondly, the tolerance for the printing misalignment of the pads 400 can be increased. Therefore, even if there is a deviation during printing the pads 400, the pads 400 are unlikely to exceed the second film portions 220 as a certain region (the region between the orthographic projection of the pad 400 and the orthographic projection of the second film portion 220 corresponding to each other) is reserved at the second film portions 220 to accommodate the deviation, such that it can ensure that during pad manufacturing, the problems of metal-induced recombination and the like caused by over-firing of the slurry are prevented.

Therefore, through the above disposal, the solar cell in the embodiments of the present invention can not only effectively improve the light utilization efficiency of the backlight surface, but also ensure the carrier transport capability of the backlight surface, and the difficulty of pad manufacturing can also be reduced, thereby avoiding the problems of over-firing from degrading the photoelectric conversion efficiency of the backlight surface. Through comprehensive improvements in the above aspects, the conversion efficiency of the backlight surface is effectively improved, thereby increasing the conversion efficiency of a photovoltaic module including the solar cells, and reducing the cost of power generation.

In an embodiment, a plurality of pads 400 and a plurality of second film portions 220 are provided, the pads 400 are disposed at intervals, and the pads 400 are respectively disposed corresponding to the second film portions 220 in a one-to-one manner.

In the embodiments of the present invention, there are a plurality of second film portions 220 and a plurality of pads 400. Since regions of the backlight surface of the solar cell corresponding to the pads 400 are light shielding regions, in this embodiment, the second film portions 220 are disposed corresponding to the pads 400 in a one-to-one manner, such that the second film portions 220 can be disposed by fully utilizing the light shielding regions of the solar cell, ensuring that the doped layer 200 has a large area, thereby ensuring the capability of the first doped layer 200 to transport carriers from the substrate 100. Furthermore, since plurality of second film portions 220 are provided, a plurality of reference structures for positioning a printing apparatus are provided when the grid lines 300 is printed, such that the precision of printing the grid lines 300 can further be improved, and parasitic absorption is further ensured on the basis of ensuring the carrier transport capability, thereby improving the capability of the backlight surface to light utilization, and increasing the bifaciality. In some embodiments, there can also be one second film portion 220, and the second film portion 220 is disposed corresponding to any one of the pads 400.

In an embodiment, in any group of a pad 400 and a second film portion 220 correspondingly disposed, an area of the pad 400 is S₁, and an area of the second film portion 220 is S₂, where 0.1≤S₁:S₂<1.

IfS₁:S₂ is less than 0.1, the area of the second film portion 220 is excessively large, increasing the parasitic absorption of light rays in the doped layer 200; and if S₁:S₂ is greater than or equal to 1, the area of the second film portions 220 is excessively small, not facilitating the positioning of the printing apparatus. Therefore, in this embodiment, S₁:S₂ is controlled at 0.1<S₁:S₂<1, the parasitic absorption of the light rays in the doped layer 200 can be minimized while the positioning of the printing apparatus is facilitated.

In an optional embodiment, 0.1 mm²≤S₁<2 mm², and 0.1 mm²<S₂<40 mm², such that the parasitic absorption of the doped layer 200 can be minimized while the positioning of the printing apparatus is facilitated. Exemplarily, Si can be 0.3 mm², 0.5 mm², 0.8 mm², 1.0 mm², 1.5 mm², 1.9 mm², or 2.0 mm², and the present invention is not limited thereto; and S₂ can be 0.5 mm², 1.5 mm², 2.9 mm², 5 mm², 9 mm², 10 mm², 15 mm², 16 mm², 18 mm², 25 mm², 32 mm², 37 mm², or 40 mm².

In an optional embodiment, shapes of the pads 400 include at least one of a rectangle, a triangle, a rhombus, a trapezoid, a cross, an I shape, a pentagon, a hexagon, a trapezoid, a circle, or an ellipse.

In this embodiment, a rectangular pad 400 is simple in manufacturing and low in cost; a circular pad 400 can reduce stress concentration, thereby improving reliability; a triangle includes three sharp angles, making it suitable for edges or narrow regions, and the triangle pad needs less slurry and thus is low in cost; the gradient design of trapezoidal, triangular, circular, elliptical, rhombus-shaped, pentagonal, and hexagonal pad 400 with widths from wide to narrow can match ribbons with different widths; and an I-shaped pad 400 can provide a larger contact area, causing a connection between the ribbon and the pad 400 to be firmer. It is to be noted that, during printing and forming, an edge of the pad 400 is jagged, with a size of a tooth being 100 µm~400 µm.

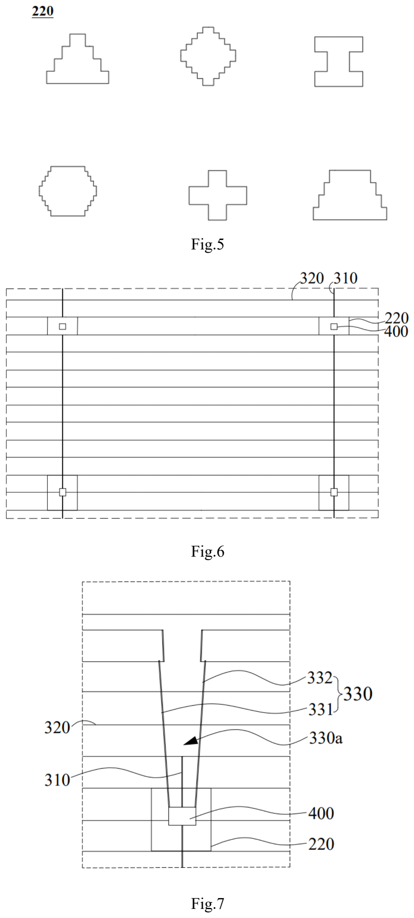

In an optional embodiment, referring to Fig. 3 and Fig. 5, shapes of the second film portions 220 includes at least one of a rectangle, a triangle, a rhombus, a trapezoid, a cross, an I shape, a pentagon, a hexagon, a circle, or an ellipse.

In this embodiment, a rectangular second film portion 220 includes a plurality of straight edges such that horizontal and vertical directions are rapidly identified during printing, thereby improving positioning efficiency; a circular or elliptical second film portion 220 includes no sharp angles, such that stress concentration can be reduced; four directions of a cross has distinct symmetry and directionality, such that precise positioning references can be provided in the horizontal and vertical directions; and an I-shaped second film portion 220 is formed by a horizontal line segment in the middle and longitudinal line segments on two ends, such that the precise positioning references can also be provided in the horizontal and vertical directions.

In an optional embodiment, the shape of a pad 400 and the shape of a second film portion 220 disposed corresponding to the pad 400 are similar or dissimilar.

In this embodiment, when the shape of the pad 400 and the shape of the second film portion 220 disposed corresponding to the pad are similar, patterned design and manufacturing are conveniently performed on a mask; and when the shape of the pad 400 and the shape of the second film portion 220 disposed corresponding to the pad are dissimilar, the shape of the second film portion 220 can be flexibly designed, facilitating the positioning of the printing apparatus.

The pads 400 are disposed on the busbar electrodes 310. There are a plurality of busbar electrodes 310 and a plurality of finger electrodes 320. A spacing between the two adjacent busbar electrodes 310 is greater than a spacing between the two adjacent finger electrodes 320. The finger electrodes 320 are disposed on the first film portion 210. The busbar electrodes 310 are disposed corresponding to the first film portion 210, and the busbar electrodes 310 disposed around the pads 400 are disposed corresponding to the second film portions 220. It is to be noted that, generally, a maximum distance between any two points on the outer contour of the pad 400 is less than the spacing between the two adjacent busbar electrodes 310.

Further, referring to Fig. 3 and Fig. 4, in this embodiment, the spacing between the two adjacent busbar electrodes 310 is greater than the spacing between the two adjacent finger electrodes 320, and the busbar electrodes 310 around the pads 400 are disposed corresponding to the second film portions 220. That is to say, after the grid lines 300 and the pads 400 are printed, if the positions of the grid lines 300 and the pads 400 are correctly printed, in the thickness direction of the substrate 100, the orthographic projection of the busbar electrodes 310 around the pads 400 must overlap the orthographic projection of the second film portions 220. In other words, after the grid lines 300 and the pads 400 are printed, in the thickness direction of the substrate 100, if the orthographic projection of the busbar electrodes 310 around the pads 400 does not overlap the orthographic projection of the second film portions 220, but is between the orthographic projections of the two adjacent busbar electrodes 310, it proves that the positions of the grid lines 300 and the pads 400 are printed incorrectly. Therefore, in this embodiment, whether the grid lines 300 and the pads 400 are printed incorrectly can be rapidly determined by observing whether the busbar electrodes 310 around the pads 400 are disposed on the second film portions 220, thereby calibrating printing results for the grid lines 300 and the pads 400.

Referring to Fig. 4, in an embodiment, the first film portion 210 includes first sub-portions 211 each disposed corresponding to the position of each busbar electrode 310, and second sub-portions 212 each disposed corresponding to the position of each finger electrode 320. That is to say, first sub-portions 211 are disposed opposite to busbar electrodes 310 in the thickness direction of the substrate 100 in a one-to-one manner, second sub-portions 212 are disposed opposite to finger electrodes 320 in the thickness direction of the substrate 100 in a one-to-one manner, and the first sub-portions 211 intersects with the second sub-portions 212.

The second film portion 220 is disposed between two second sub-portions 212, and at least one edge of the second film portion 220 in a length extending direction of the first sub-portion 211 is attached to a corresponding second sub-portion 212. That is to say, in the length extending direction of the first sub-portion 211, there is no gap between the at least one edge of the second film portion 220 and the corresponding second sub-portion 212.

In this embodiment, in the length extending direction of the first sub-portion 211, there is no gap between the at least one edge of the second film portion 220 and the corresponding second sub-portion 212, such that good overall connectivity of the structure of the doped layer 200 can be achieved, facilitating improvement of cooperation with the substrate 100, thereby improving the carrier transport capability. Furthermore, since in the length extending direction of the first sub-portions 211, there is no gap between the at least one edge of the second film portion 220 and the corresponding second sub-portion 212, the difficulty of depositing other functional layers (for example, functional layers such as a passivation layer and an anti-reflection layer) on the patterned doped layer 200 can be reduced, thereby reducing the problems of poor deposition quality of the functional layers, difficult deposition in gaps, the presence of bubbles caused by numerous gaps.

Furthermore, after the grid lines 300 and the pads 400 are printed, if the positions of the grid lines 300 and the pads 400 are correctly printed, in the length extending direction of the first sub-portions 211, the at least one edge of the second film portion 220 is attached to the corresponding second sub-portion 212. In other words, after the grid lines 300 and the pads 400 are printed, the edge of the second film portion 220 that needs to be attached to the corresponding second sub-portion 212 is not attached to the corresponding second sub-portion 212, but there is a gap between the edge of the second film portion 220 and the corresponding second sub-portion 212, it proves that the positions of the grid lines 300 and the pads 400 are printed incorrectly. Therefore, in this embodiment, whether the grid lines 300 and the pads 400 are printed incorrectly can be rapidly determined by observing whether the edge of the second film portion 220 that needs to be attached to the corresponding second sub-portion 212 is attached to the corresponding second sub-portions 212, thereby calibrating printing results for the grid lines 300 and the pads 400.

In an embodiment, further referring to Fig. 4 and Fig. 6, a second film portion 220 is disposed between two adjacent second sub-portions 212. That is to say, a size of the second film portion 220 in the length extending direction of the first sub-portion 211 is less than or equal to the spacing between the two adjacent second sub-portions 212, such that the second film portion 220 with a smaller area to further reduce the parasitic absorption of the doped layer 200.

Alternatively, in an embodiment, a second film portion 220 is disposed between two non-adjacent second sub-portions 212, and one or more second sub-portion 212 is disposed between the two second sub-portions 212 which are not adjacent to each other. That is to say, the size of the second film portion 220 in the length extending direction of the first sub-portion 211 is greater than the spacing between the two adjacent second sub-portions 212, such that the second film portion 220 with a large area to reserve a larger size or more-allowable deviation range for pad manufacturing. Therefore, on the basis of ensuring that the pad 400 is not easy to exceed the range of the second film portion 220, pad with a larger size can be manufactured on the second film portion 220 with the larger area, thereby the larger pad can provide a larger welding tensile force to ensure better structural stability when the photovoltaic module is formed by the plurality of solar cells.

In some embodiments, the auxiliary electrodes 330 include at least one of a forked-shape grid line, a wave-shaped grid line, or a cross-shaped grid line. By disposing the auxiliary electrodes 330 of the above shape near the end portions of the busbar electrodes 310, the efficiency of collecting carriers close to the edge region of the solar cell is improved, a degree of stress concentration is dispersed, and the uneven bulging of the slurry in such regions during the printing of the slurry is avoided, thereby solving the problem of insufficient soldering.

The doped layer 200 further includes third film portions (not shown in the figure) disposed corresponding to positions of the auxiliary electrodes 330; and in the thickness direction of the substrate 100, an orthographic projection of the auxiliary electrodes 330 on the substrate 100 is contained in an orthographic projection of the third film portions on the substrate 100. By disposing the corresponding third film portions under the auxiliary electrodes 330, an effect similar to the second film portions 220 can be achieved to optimize and protect the performance of the edge region of the solar cell, thereby ensuring the edge region of the solar cell also with good light utilization efficiency and carrier transport capability, as well as low difficulty of grid line manufacturing. The third film portions disposed corresponding to positions of the auxiliary electrodes 330, means that, in the thickness direction of the substrate, the third film portions are disposed opposite to the auxiliary electrodes 330.

In some embodiments, each of the auxiliary electrodes 330 is the forked-shape grid line, that is, a fish fork-shaped auxiliary electrode 330. Further referring to Fig. 7, there are a plurality of forked-shape grid lines; any one of the forked-shape grid lines includes a first fork line 331 and a second fork line 332, which are approximately disposed in the length extending direction of the busbar electrode; and the first fork line 331 and the second fork line 332 are disposed at intervals, in the length extending direction of the finger electrode 320, to form an interval region 330a. The first fork line 331 and the second fork line 332 are approximately disposed in the length extending direction of the busbar electrode, means that, the length extending direction of the first fork line 331 and that of the second fork line 332 are both intersects with the length extending direction of the busbar electrode 310 at a small included angle.

Further, the end portion of the busbar electrode 310 is disposed in the interval regions 330a. That is to say, the auxiliary electrode 330 is close to the end portion of the busbar electrode 310. Specifically, the end portion of the busbar electrode 310 extends into the interval region 330a of the auxiliary electrodes 330 to improve binding performance between the busbar electrode 310 and the auxiliary electrode 330. It can be understood that, the auxiliary electrode 330 can also be directly connected to the end portion of the busbar electrode 310, and the present invention is not limited thereto. Furthermore, the finger electrode 320 is in the interval region 330a. That is to say, in the interval region 330a of the auxiliary electrode 330, an end portion of a small section of busbar electrode 310 can extend in, and a small number of finger electrodes 320 can also pass through, so as to improve the capability and mechanical strength of the grid lines in the edge region of the solar cell to collect the carriers, thereby ensuring that the film properties of the edge region of the solar cell and other positions of the solar cell are highly consistent , with minimal variation.

In some embodiments, the third film portions can only be correspondingly disposed under the auxiliary electrodes 330, that is, the third film portions are only disposed under positions disposed first fork lines 331 and second fork lines 332, and the third film portions are not disposed under interval regions 330a. In some other embodiments, the third film portions can also be disposed corresponding to positions of interval regions 330a, that is, the third film portions are disposed under the positions disposed first fork lines 331 and second fork lines 332, and third film portions are also disposed under interval regions 330a. In other words, the third film portions are disposed under the entire region of the auxiliary electrodes 330. The structural feature can reduce the manufacturing complexity of the third film portions, facilitating increasing of production capability.

Different regions of the backlight surface of the solar cell are described below.

In an embodiment, referring to Fig. 1 to Fig. 4 again, the backlight surface includes a first region 1A and a second region 1B disposed outside the first region 1A, the first region 1A corresponds to the position of the doped layer 200, the second region 1B here refers to a region of the backlight surface that is not covered by the doped layer 200, and the first region 1A refers to a region of the backlight surface that is covered by the doped layer 200.

In an embodiment, an area of the first region 1A is S_{A1}, an area of the second region 1B is S_{A2}, and S_{A2}:S_{A1} is 0.5~50. Exemplarily, S_{A2}:S_{A1} can be 0.5, 0.6, 0.8, 1, 2, 3, 4, 5, 6, 10, 20, 25, 30, 36, 39, 45, 48, or 50, and the present invention is not limited thereto.

If S_{A2}:S_{A1} is less than 0.5, the area of the doped layer 200 covering the backlight surface is too large, and the reduction in the area proportion of the doped layer 200 is insufficient, weakening a reduction degree of parasitic absorption; and if S_{A2}:S_{A1} is greater than 50, the area of the doped layer 200 covering the backlight surface is too small, and the reduction in the area proportion of the doped layer 200 is excessive, leading to the weakening of the carrier transport capability and field passivation effect of the doped layer. Therefore, in this embodiment, S_{A2}:S_{A1} is controlled at 0.5-50, such that the parasitic absorption of light is reduced, the conversion efficiency of the backlight surface is improved, and the doped layer 200 is ensured to have a larger area, thereby ensuring the transport capability of the doped layer 200 to the carriers in the substrate 100.

In a further embodiment, S_{A2}:S_{A1} is 1~50, such that the conversion efficiency and carrier transport capability of the backlight surface can be further improved. In a further embodiment, S_{A2}:S_{A1} is 1~6, such that the conversion efficiency and carrier transport capability of the backlight surface can be further improved.

In an embodiment, further referring to Fig. 4 again, the first region 1A includes first sub-regions 1A1 disposed corresponding to the position of the first film portion 210, and second sub-regions 1A2 disposed corresponding to the positions of the second film portions 220; in the thickness direction of the substrate 100, the second sub-regions 1A2 overlap with the orthographic projection of the second film portions 220 on the substrate 100. That is to say, the first region 1A of the backlight surface of the solar cell covered by the doped layer 200 can also be divided into the first sub-regions 1A1 and the second sub-regions 1A2 according to corresponding positions of the first film portion 210 and second film portions 220 of the doped layer 200, and the second sub-regions 1A2 overlap with the orthographic projection of the second film portions. The first sub-regions 1A1 are disposed corresponding to the position of the first film portion 210, and the second sub-regions 1A2 are disposed corresponding to the positions of the second film portions 220, means that, in the thickness direction of the substrate, the first sub-regions 1A1 are disposed opposite to the first film portion 210, and the second sub-regions 1A2 are disposed opposite to the second film portions 220.

Observing from a direction of the backlight surface, there is a color difference in the second sub-region 1A2 and the second region 1B of the solar cell. That is to say, there is a color difference between the portion of the backlight surface structure of the solar cell that is disposed corresponding to the second sub-regions 1A2 and the portion of the backlight surface structure of the solar cell that is disposed corresponding to the second region 1B. It is to be noted that, the backlight surface structure refers to a film structure of the solar cell that is disposed on a backlight surface of the substrate 100. For example, the backlight surface structure of the solar cell can include the patterned doped layer 200 disposed on the substrate 100, and a passivation layer disposed on the doped layer 200 and a portion of the substrate 100 that is not covered by the doped layer 200. In this case, in the second region 1B of the backlight surface of the solar cell, the backlight surface structure of the solar cell includes the passivation layer. In the second sub-regions 1A2 of the backlight surface of the solar cell, the backlight surface structure of the solar cell includes the passivation layer, and the doped layer 200 disposed between the passivation layer and the substrate 100.

Furthermore, the above color difference means that, when viewing from the backlight surface of the solar cell, colors in the second sub-regions 1A2 and the second region 1B are different. It is to be noted that, the different colors in the second sub-regions 1A2 and the second region 1B means that the eyes of the observer can observe that the backlight surface of the entire solar cell shows different colors in different regions, rather than different colors are disposed in different regions of a film on the backlight surface of the solar cell. Exemplarily, the color of the solar cell in the second sub-regions 1A2 can be light white, and the color of the solar cell in the second region 1B can be black. For another example, the color of the solar cell in the second sub-regions 1A2 can be light blue, and the color of the solar cell in the second region 1B can be dark blue. Therefore, the solar cell shows a color difference in different regions.

In this embodiment, the second region 1B is the region of the backlight surface that is not covered by the doped layer 200, the first region 1A is the region of the backlight surface that is covered by the doped layer 200, the first sub-regions 1A1 of the first region 1A are covered by the first film portion 210, the second sub-regions 1A2 of the first region 1A are covered by the second film portions 220, the second film portions 220 corresponds to the position of the pads 400, and the outer contour of the second film portion 220 exceeds the outer contour of the pad 400 corresponding to each other, such that the second sub-regions 1A2 completely overlap with the second film portions 220, causing a portion of the second sub-region 1A2 to be exposed from the pad 400, that is, the pad 400 does not completely cover the second sub-region 1A2. In this way, by the color difference of the solar cell in the second sub-regions 1A2 and the second region 1B, the second film portions 220 can become more significant reference structures, facilitating further reduction in printing difficulty, thereby ensuring the accuracy of printing alignment.

In an embodiment, in the thickness direction of the substrate 100, the first sub-regions 1A1 overlap with the orthographic projection of the first film portion 210 on the substrate 100, and the orthographic projection of the grid lines 300 on the substrate 100 is contained in the range of the orthographic projection of the first film portion 210 on the substrate 100. That is to say, in the direction perpendicular to the thickness direction of the substrate 100, the outer contour of the first film portion 210 exceeds the outer contour of the grid lines 300.

In this embodiment, the size of the first film portion 210 is greater than the size of the grid lines 300. In the thickness direction of the substrate 100, the orthographic projection of the grid lines 300 on the substrate 100 is contained in the range of the orthographic projection of the first film portion 210 on the substrate 100, such that a larger error range can be reserved for the printing of the grid lines 300, so as to prevent the grid lines 300 from deviating beyond the first film portion 210 during the printing of the grid lines 300.

In an embodiment, the first region 1A further includes third sub-regions disposed corresponding to positions of the third film portions. In the thickness direction of the substrate 100, the third sub-regions overlap with the orthographic projection of the third film portions on the substrate 100.

In an embodiment, the reflectivity of the solar cell in the first region 1A of the backlight surface is R₁, that is to say, the reflectivity of the portion of the backlight surface structure of the solar cell that is disposed corresponding to the first region 1A is R₁. The reflectivity of the solar cell in the second region 1B of the backlight surface is R₂, that is to say, the reflectivity of the portion of the backlight surface structure of the solar cell that is disposed corresponding to the second region 1B is R₂. R₁ is different from R₂. It is to be noted that, the backlight surface structure refers to a film structure of the solar cell that is disposed on the backlight surface of the substrate 100.

In this embodiment, the second region 1B is the region of the backlight surface that is not covered by the doped layer 200, the first region 1A is the region of the backlight surface that is covered by the doped layer 200, the reflectivity of the solar cell in the first region 1A of the backlight surface is R₁, the reflectivity of the solar cell in the second region 1B of the backlight surface is R₂, and R₁ is different from R₂. Thus, the solar cell can show different color in the first region 1A and the second region 1B, and the second film portions 220 is disposed corresponding to the first region 1A, such that the second film portions 220 can become more significant reference structures through such disposal, facilitating further reduction in printing difficulty, thereby ensuring the accuracy of printing alignment.

In an embodiment, R₁>R₂.

In this embodiment, the reflectivity of the solar cell in the second region 1B of the backlight surface is smaller, the second region 1B is the region that is not covered by the doped layer 200, and the low reflectivity of the region can reduce the reflection of the substrate 100 to light entering from the backlight surface, such that more light rays can enter the substrate 100 from the backlight surface to further improve the light utilization efficiency of the backlight surface of the solar cell, thereby further improving the conversion efficiency of the backlight surface of the solar cell. In particular, when S_{A2}: S_{A1} is 1~50, the area proportion of the second region 1B on the backlight surface is larger, that is, the area of the region with lower reflectivity is larger, facilitating improvement of the light utilization capability of the backlight surface.

In another embodiment, R₁ < R₂, and a difference value between R₂ and R₁ is less than or equal to 10%, such that the second film portions 220 can become more significant reference structures, ensuring the accuracy of printing alignment.

In an embodiment, R₁ is 12%~25%, and R2 is 0.5%~25%. Exemplarily, R₁ can be 13%, 14%, 15%, 16%, 17%, 20%, 22%, or 24%; and R₁ can be 0.8%, 1%, 5%, 8%, 10%, 11%, 14%, 15%, 20%, 22%, or 24%.

In this embodiment, R₁ is controlled at 12%~25%, and R₂ is controlled at 0.5%~25%, such that the second film portions 220 can become more significant reference structures, and more light rays can enter the substrate 100, thereby improving the conversion efficiency of the solar cell.

In a further embodiment, R₁ is 13%~17%, and R₂ is 0.5%~15%. In another further embodiment, R₁ is 13%~17%, R₂ is 0.5%~8%.

It is to be noted that, the reflectivity of the solar cell of the embodiments of the present invention in different regions can be obtained through testing by a full spectrum microspectrometer. The full spectrum microspectrometer can perform optical index measurement within an ultraviolet light-visible light-near infrared light spectral range on a sample region with a size less than or equal to 1 micron, and support full-wave analysis from deep ultraviolet light to near-infrared light. Optical indexes measurable by the device include, but are not limited to: reflectivity, transmittance, and absorbance. In addition, the reflectivity of different regions can also be tested by a Raman tester capable of testing micrometer-scale sample regions. Devices for testing the reflectivity of different regions are not limited in the embodiments of the present invention.

In an embodiment, a first textured surface structure is disposed on the portion of the backlight surface of the substrate 100 in the first region 1A, a second textured surface structure is disposed on the portion of the backlight surface of the substrate 100 in the second region 1B, and the first textured surface structure and the second textured surface structure are different. It is to be noted that, the first textured surface structure and the second textured surface structure are different means that the first textured surface structure and the second textured surface structure are different in at least one of shape or size, they can be same or similar to shapes but different in sizes, can be different in shapes but same or similar to sizes, or can also be different both in shapes and sizes.

In this embodiment, by means of disposing the first textured surface structure in the first region 1A, disposing the second textured surface structure in the second region 1B, and disposing the two textured surface structures with different structures, the reflectivity of the solar cell in the first region 1A and second region 1B of the backlight surface can be different, and the solar cell can show different colors in the first region 1A and the second region 1B. Since the second film portions 220 is disposed corresponding to the first region 1A, the second film portions 220 can become more significant reference structures through such disposal, facilitating further reduction in printing difficulty, thereby ensuring the accuracy of printing alignment.

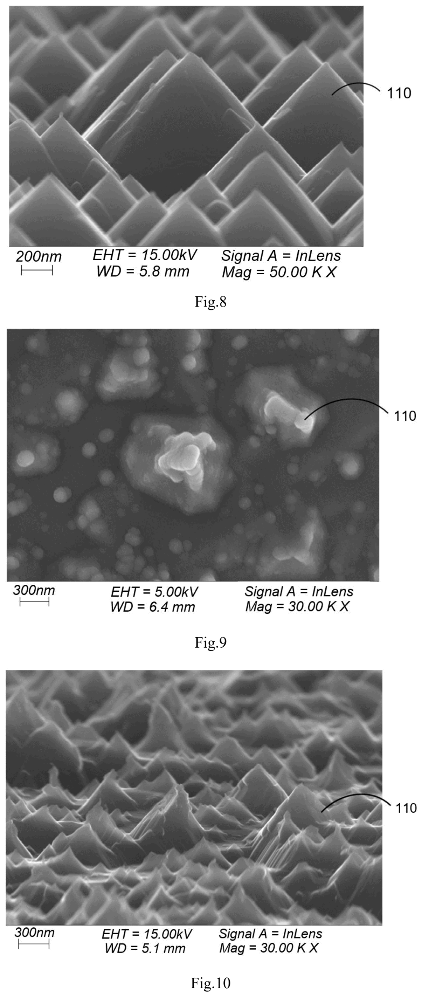

In an embodiment, referring to Fig. 8 to Fig. 11, the second textured surface structure includes at least one of protruding structures 110 or recessed structures 120.

In this embodiment, the protruding structure 110 and the recessed structure 120 both can cause incident light to be reflected for a plurality of times in the second textured surface structure, so as to lengthening a propagation path of the light in the substrate 100, thereby increasing an absorption rate of the light.

In an embodiment, the protruding structures 110 include at least one of upright pyramids, truncated pyramids, or curved protrusions. Exemplarily, a peripheral surface of the curved protrusion is a curved surface.

In this embodiment, the upright pyramids can effectively reduce the reflection of the light, and increase the propagation paths of the light in a silicon wafer through a plurality of times of reflection and scattering, thereby increasing the absorption rate of the light. The truncated pyramid further reduces reflection losses of the light and simultaneously increases the propagation paths of the light in the silicon wafer, by optimizing the surface angle. The curved protrusion can scatter the light more effectively, reduce light reflection, and can better adapt to light at different angles of incidence, thereby increasing the absorption rate of the light.

In an embodiment, a micro-etched structure is disposed on an outer surface of each of the protruding structures 110. That is to say, the outer surface of the protruding structure 110 further provided with an uneven micro-etched structure. These micro-etched structures can be formed on the outer surface of the protruding structures 110 through secondary etching. For example, a micro-etched structure can be a depression structure, a threaded structure, an irregularly groove structure Therefore, surface roughness and complexity of the protruding structures can be enhanced, the reflection and scattering effect of the incident light is improved, the propagation paths of the light rays is further lengthened, and more light rays are absorbed, thereby increasing the absorption rate of the light.

In an embodiment, the protruding structures 110 include the upright pyramids. It is to be noted that, in the embodiments of the present invention, each upright pyramid refers to a pyramid-shaped protruding structure that is formed by outward protruding from the surface of the substrate 100 in a direction away from the substrate 100, and is opposite to the inverted pyramid below. The inverted pyramid below refers to a pyramid-shaped recessed structure that is formed by recessing inward from the surface of the substrate 100 in a direction towards the inside of the substrate 100.

A side length of a base of the upright pyramid is 0.2 µm-3.5 µm, such that the reflection of the light can be reduced more effectively, the propagation paths of the light in the silicon wafer are increased through a plurality of times of reflection and scattering, thereby increasing the absorption rate of the light. Exemplarily, the side length of the base of the upright pyramid can be 0.3 µm, 0.4 µm, 05 µm, 0.9 µm, 1.5 µm, 2.0 µm, 2.8 µm, or 3.3 µm.

The outer surface of the upright pyramid is disposed with the micro-etched structure, such that protruding surface roughness can be enhanced, and the utilization of the incident light is improved, thereby improving the conversion efficiency of the backlight surface.

The reflectivity of the solar cell in the first region 1A of the backlight surface is 0.5%~8.0%. Exemplarily, the reflectivity of the solar cell in the first region 1A of the backlight surface can be 0.6%, 0.7%, 0.8%, 0.9%, 1.5%, 3%, 4%, 5.6%, 6.2%, or 7.5%. Therefore, there is a significant difference in the reflectivity of the first region 1A and the second region 1B such that the second film portions 220 becomes more significant reference structures, facilitating further reduction in printing difficulty, thereby ensuring the accuracy of printing alignment.

In an embodiment, the protruding structures 110 include the truncated pyramids, and the truncated pyramids include at least one of regular truncated pyramids or irregular truncated pyramids.

A side length of a base of each of the truncated pyramids is 0.2 µm~3.5 µm. Exemplarily, the side length of the base of a truncated pyramid can be 0.3 µm, 0.5 µm, 0.8 µm, 1.1 µm, 2.5 µm, 3.1 µm, or 3.3 µm, such that the reflection losses of the light can be further reduced while the propagation paths of the light in the silicon wafer are simultaneously increased.

An outer surface of each of the truncated pyramids is disposed with the micro-etched structure. Therefore, surface roughness and complexity of the protruding structures can be enhanced, the reflection and scattering effect of the incident light is improved, the propagation paths of the light rays is further lengthened, and more light rays are absorbed, thereby increasing the absorption rate of the light.

The reflectivity of the solar cell in the first region 1A of the backlight surface is 0.5%~20.0%. Exemplarily, the reflectivity of the solar cell in the first region 1A of the backlight surface can be 0.6%, 0.7%, 0.8%, 0.9%, 1%, 4%, 6%, 8%, 11%, 12%, 13%, 14.5%, 15%, 18%, or 20%. Therefore, there is a significant difference in the reflectivity of the first region 1A and the second region 1B, such that the second film portions 220 become more significant reference structures, facilitating further reduction in printing difficulty, thereby ensuring the accuracy of printing alignment.

In an embodiment, the protruding structures 110 include the curved protrusions.

A height of each of the curved protrusions is less than1.5 µm. Exemplarily, the height of a curved protrusion can be 0.5 µm, 0.8 µm, 1.2 µm, 1.3 µm, or 1.4 µm. By controlling the height of the curved protrusion, the scattering and reflection of the incident light can be realized more effectively, and the loss of the light is reduced, thereby improving the absorption efficiency of the light. Furthermore, a smaller height of the curved surface can reduce a surface defect density, and reduce combination losses of the carriers on the surface, thereby improving the collection efficiency of the carriers.

An outer surface of each of the curved protrusions is disposed with the micro-etched structure. Therefore, surface roughness and complexity of the curved protrusion can be enhanced, the reflection and scattering effect of the incident light is improved, the propagation paths of the light rays is further lengthened, and more light rays are absorbed, thereby increasing the absorption rate of the light.

The reflectivity of the solar cell in the first region 1A of the backlight surface is 5.0%~25.0%. Exemplarily, the reflectivity of the solar cell in the first region 1A of the backlight surface can be 6%, 8%, 10%, 14%, 16%, 18%, 21%, 23%, or 24%. Therefore, there is a significant difference in the reflectivity of the first region 1A and the second region 1B such that the second film portions 220 become more significant reference structures, facilitating further reduction in printing difficulty, thereby ensuring the accuracy of printing alignment.

In an embodiment, the recessed structures 120 include at least one of the following: dispersed pits, a pit island formed by a plurality of interconnected pits, or inverted pyramids.

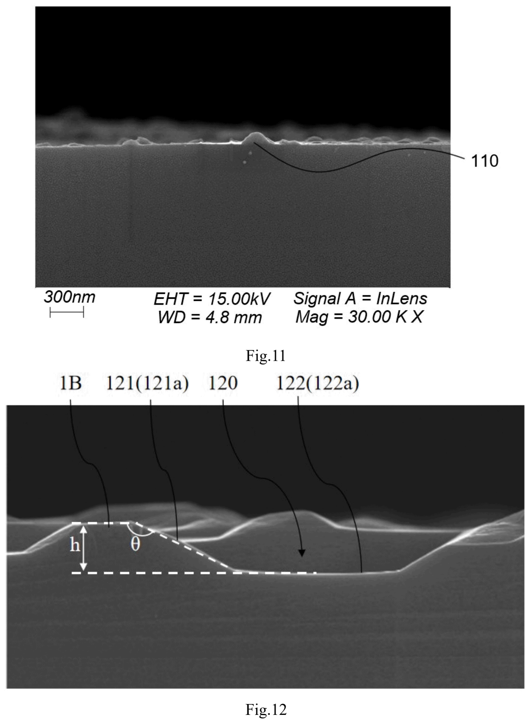

Further referring to Fig. 12, a depth of each of the recessed structure 120 disposed relative to a portion of the backlight surface in the second region 1B is 0.2 µm~10.0 µm. Exemplarily, a depression depth can be 0.2 µm, 0.5 µm, 0.8 µm, 1.1 µm, 2.8 µm, 3.4 µm, 5.0 µm, 6.3 µm, 8 µm, or 9 µm. By controlling the depression depth of the recessed structure 120 at 0.2 µm~10.0 µm, the reflectivity of the light on the surface of the cell can be significantly reduced, and the propagation paths of the light in an absorption layer is simultaneously increased, thereby increasing the absorption rate of the light. It is to be noted that, the depression depth refers to a vertical distance between a bottom of the recessed structure 120 and a portion of the backlight surface disposed in the second region 1B. For example, in Fig. 12, when the recessed structure 120 is an inverted trapezoidal pit, the depression depth refers to a vertical distance between a bottom wall 122 of the inverted trapezoidal pit and a portion of backlight surface disposed in the second region 1B. When a recessed structure is an inverted pyramid, the depression depth refers to a vertical distance between a bottom sharp angle end of the inverted pyramid and a portion of the backlight surface disposed in the second region 1B.

A tilt angle of a side wall of the recessed structure 120 disposed relative to the backlight surface of the second region 1B is θ, and 90° < θ < 170°. Exemplarily, θ can be 100°, 105°, 110°, 130°, 145°, 150°, or 165°. In this embodiment, by optimizing the tilt angle of the recessed structure 120, 90° < θ < 170°, such that the direct reflection of the light can be reduced, thereby further reducing the reflectivity of the cell surface. For example, when the recessed structure 120 is the inverted trapezoidal pit, referring to Fig. 12, the tilt angle θ refers to an included angle between a side wall 121 and the bottom wall 122 of the inverted trapezoidal pit. Specifically, a cross section of the recessed structure 120 parallel to its own axis includes a first side line 121a and a second side line 122a, which intersect with each other; the first side line 121a is on the side wall 121 of the recessed structure 120, and the second side line 122a is on the bottom wall of the recessed structure 120; and θ is an included angle between the first side line 121a and the second side line 122a. For another example, when the recessed structure 120 is the inverted pyramid, the tilt angle θ refers to an included angle between a side wall of the inverted pyramid and a portion of the backlight surface disposed in the second region.

A maximum distance between any two points on an opening contour of each of the recessed structures 120 is 2 µm~40 µm. Exemplarily, the maximum distance between any two points on the opening contour of a recessed structure 120 can be 5 µm, 10 µm, 12 µm, 18 µm, 22 µm, 26 µm, 30 µm, 35 m, or 38 µm. By controlling the above maximum distance at 2 µm~40 µm, a light trapping effect of the pit can be optimized, such that the incident light is reflected and scattered in the pit for a plurality of times, thereby lengthening the propagation paths of the light in the cell, and increasing the absorption rate of the light.

The reflectivity of the solar cell in the first region 1A of the backlight surface is 5.0%~25.0%. Exemplarily, the reflectivity of the solar cell in the first region 1A of the backlight surface can be 6%, 8%, 10%, 14%, 16%, 18%, 21%, 23%, or 24%. Therefore, there is a significant difference in the reflectivity of the first region 1A and the second region 1B such that the second film portions 220 become more significant reference structures, facilitating further reduction in printing difficulty, thereby ensuring the accuracy of printing alignment.

In an embodiment, the first textured surface structure includes a plurality of boss structures.

The plurality of boss structures are disposed at intervals relative to each other, or a stacked crossover region exists between the plurality of boss structures. More uniform light distribution can be realized by designing a stacked crossover structure, such that excessive or insufficient local light intensity is avoided, thereby improving the overall performance of the cell.

A side length of a bottom of each boss structure is 0.5 µm~8 µm, a side length of a top of each boss structure is 0.2 µm~4 µm, and a height of each boss structure is 0.1 µm~5 µm, such that the recycling of the long wavelength light passing through the substrate 100. Exemplarily, a side length of bottom of the boss structure can be 0.5 µm, 0.8 µm, 1.2 µm, 2 µm, 4 µm, 5 µm, 7 µm, or 8 µm.

A shape of a cross section of the boss structure is a rectangle, a rhombus, a trapezoid, or an irregular polygon. The boss structure of the above shape can better disperse the light rays, reduce the direct reflection of backlight, reduce the transmission of front long wavelength light, better adapt to characteristics of different crystal orientations, and effectively improve the absorption of the light, especially in a crystalline silicon solar cell.

In an embodiment, a recessed depth of a surface of the substrate in the second region 1B relative to a surface of the substrate in the first region 1A is h, and 0.1 µm < h < 7 µm. Exemplarily, h can be 0.2 µm, 0.5 µm, 1.0 µm, 1.5 µm, 2.3 µm, 3.1 µm, 3.8 µm, 4.5 µm, 4.9 µm, 5 µm, 5.5 µm, 6 µm, 6.5 µm, or 7 µm.

In this embodiment, the portion of the backlight surface disposed in the second region 1B recesses relative to the portion of the backlight surface disposed in the first region 1A, such that the second region 1B is not covered by the doped layer 200 to ensure the parasitic absorption of the portion is eliminated. Furthermore, this embodiment also optimizes the recessed depth of the second region 1B, making 0.1 µm < h < 7 µm, such that the parasitic absorption of the second region 1B is less, and there is a high probability that the light is be reflected back to the substrate 100 for recycling. Due to a significant height difference and functional division of work of the first region 1A and the second region 1B, the former for carrier transportation, and the latter for passivation of optical structures, thereby achieving efficient operation of devices.

In an embodiment, the solar cell further includes a back-side passivation and anti-reflection layer and a patterned back-side dielectric layer.

The back-side passivation and anti-reflection layer 500 is disposed on a surface of the doped layer 200 away from the substrate 100 and on the substrate 100 that is not covered by the doped layer 200, where at least a portion of the grid lines 300 is in ohmic contact with the doped layer 200 by passing through the back-side passivation and anti-reflection layer 500.

When the light rays irradiate the backlight surface of the solar cell, if there is no back-side passivation and anti-reflection layer 500, a significant portion of the light rays is reflected back into the air, and unable to enter the inside of the cell to be absorbed and converted into electrical energy. By adjusting the thickness and refractive index of the back-side passivation and anti-reflection layer 500, the incident light is reflected and transmitted on a film interface for a plurality of times. These reflected waves interfere with each other, causing the light intensity at specific wavelengths reflected back into the air to be weakened, thereby increasing the intensity of the light rays entering the substrate 100.

The patterned back-side dielectric layer 600 is disposed between the substrate 100 and the doped layer 200. The back-side dielectric layer 600 and the doped layer 200 jointly form a passivated contact structure, which can provide a transmission channel for tunneling carriers and can also achieve a field passivation effect of the doped layer 200, thereby improving the passivation performance of the backlight surface of the solar cell.

In an embodiment, a material of the back-side passivation and anti-reflection layer 500 includes at least one of a silicon dioxide layer, a silicon nitride layer, a silicon oxynitride layer, an aluminum oxide layer, a magnesium oxide layer, a zinc sulfide layer, or a titanium dioxide layer. The back-side dielectric layer 600 includes at least one of a silicon oxide layer, a magnesium fluoride layer, an amorphous silicon layer, a polycrystalline silicon layer, a silicon carbide layer, a silicon nitride layer, a silicon oxynitride layer, an aluminum oxide layer, or a titanium oxide layer.

In an embodiment, the substrate 100 also includes a light-receiving surface disposed opposite to the backlight surface. A front-side doped layer 700 is disposed on the light-receiving surface, and a front-side passivation anti-reflection layer 800 is disposed on the surface of the front-side doped layer 700 facing away from the light-receiving surface. The solar cell further includes front-side grid lines 900, and the front-side grid lines 900 are in ohmic contact with the front-side doped layer 700 by passing through the front-side passivation anti-reflection layer 800.

In a second aspect, embodiments of the present invention further provide a method for manufacturing the solar cell as described in the first aspect. The method includes the following steps.

A doped layer disposed between a substrate and a mask layer is patterned, so as to form a first region and a second region disposed outside the first region, which are different in pattern;
a portion of the doped layer in the second region is etched until a surface of the substrate in the second region is exposed;
the remaining mask layer is removed to expose the patterned doped layer, where the patterned doped layer includes a first film portion and second film portions; and
grid lines and pads are formed on the patterned doped layer such that busbar electrodes and finger electrodes are disposed on the first film portion, the pads are disposed on the second film portions, and in a thickness direction of the substrate, an orthographic projection of the pads on the substrate is contained in a range of an orthographic projection of the second film portion on the substrate.

Patterning the doped layer can be implemented through technical means such as laser patterning or wet etching. After patterning, the properties of at least a portion of the mask layer changed. For example, a portion of the mask layer can be removed to expose the doped layer; the thickness of a portion of the mask layer can be reduced but not completely removed; a portion of the mask layer and the doped layer under the mask layer can be removed to expose the substrate; and the film properties of a portion of the mask layer change but is not reduced, and the portion of the mask layer with the film properties changed is removed through subsequent chemical etching. The above patterning is not limited in the present invention.

In conclusion, through patterning, the properties of a portion of the mask layer changed, the doped layer under this portion of the mask layer is removed in subsequent treatment, and the properties of another portion of the mask layer do not change, such that the doped layer covered can be protected, thereby achieving the patterning of the doped layer. In the embodiments of the present invention, for the first region and the second region with different patterns, due to the patterning, the backlight surface can be divided into different first region and second region according to the patterned doped layer. Furthermore, the second region refers to the region in which the mask layer and doped layer are removed, and the first region is the region that reserves the doped layer.

After patterning, the remaining mask layer in the second region is then removed by etching, so as to obtain the patterned doped layer, and the doped layer includes the first film portion for disposing the grid lines and the second film portions for disposing the pads. Further, the embodiments of the present invention dispose the busbar electrodes and the finger electrodes above the first film portion and dispose the pads above the second film portions, and the orthographic projection of the pads on the substrate are disposed within the range of the orthographic projection of the second film portions on the substrate, such that the solar cell of the first aspect is obtained.

It can be understood that, before forming the grid lines and the pads on the patterned doped layer, the embodiments of the present invention can further include steps of forming other films. For example, a passivation anti-reflection layer is deposited on the patterned doped layer, and then the grid lines and the pads of which positions correspond to the patterned doped layer are formed on the passivation anti-reflection layer. For another example, a dielectric layer is formed on the substrate before the doped layer is formed on the substrate, and then the dielectric layer and the doped layer both are patterned. For another example, structures such as an emitter, a passivation layer, an anti-reflection layer are formed on the light-receiving surface of the substrate. The above film structure can be formed by conventional processes in the art, and the present invention is not limited thereto.

In some embodiments, the doped layer further includes the third film portions. The grid lines further include the auxiliary electrodes. After the grid lines and the pads are formed on the patterned doped layer, in the thickness direction of the substrate, the orthographic projection of the auxiliary electrodes is contained in the range of the orthographic projection of the third film portions on the substrate.

In some embodiments, etching the portion of the doped layer in the second region includes:
A second textured surface structure is formed on the surface of the substrate in the second region through isotropic etching, anisotropic etching, or a combination of one or both types of etching.

In some embodiments, etching the portion of the doped layer in the second region includes:
isotropic etching is performed first, and then anisotropic etching is performed, so as to obtain the second textured surface structure including upright pyramids or curved protrusions.

In some embodiments, etching the portion of the doped layer in the second region includes:
anisotropic etching is performed first, and then isotropic etching is performed, so as to obtain the second textured surface structure including truncated pyramids.

In some embodiments, etching the portion of the doped layer in the second region includes:
isotropic etching is performed for at least two times, so as to obtain the second textured surface structure including recessed structures.

In some embodiments, etching the portion of the doped layer in the second region includes: anisotropic etching is performed for at least two times, so as to obtain the second textured surface structure including the upright pyramids. That is to say, in regardless of performing isotropic etching first or performing anisotropic etching first, the obtaining of the upright pyramids is more facilitated when the last etching process is anisotropic etching.

It can be seen that, in the method of the embodiments of the present invention, the portion of doped layer in the second region is etched through one or both types of isotropic etching and anisotropic etching, such that the second textured surface structure is formed in the second region. By controlling different times for etching, using different etching sequences, the second textured surface structures in the different shapes above can be obtained respectively.

In some embodiments, conditions for the isotropic etching include: a temperature being 50 °C~85 °C, a time being 50 s~800 s, a concentration of an alkaline solution being 0.1 wt%~1.6 wt%, and a concentration of an additive being 0.1 wt%~2 wt%, where an alkaline agent in the alkaline solution includes at least one of sodium hydroxide or potassium hydroxide, and components in the additive include at least one of lignin or cellulose.

In some embodiments, in the isotropic etching treatment, an etching rate ratio of a crystal plane (110) and a crystal plane (111) of the substrate is greater than or equal to 5, and an etching rate ratio of a crystal plane (100) and the crystal plane (111) of the substrate is greater than or equal to 5.

In some embodiments, process parameters for the anisotropic etching include: a temperature being 30 °C~85 °C, a time being 10 s~500 s, a concentration of an alkaline solution being 0.1 wt%~40 wt%, and a concentration of an additive being 0.1 wt%~4 wt%, where an alkaline agent in the alkaline solution includes at least one of sodium hydroxide or potassium hydroxide, and components in the additive include at least one of a quaternary ammonium salt, a 1-hydroxyethylidene-1,1-dishosphonic acid, or a sulfate.

In addition to using the etching means of isotropic etching and/or anisotropic etching, the embodiments of the present invention can further perform micro-etched after the above etching means, and/or perform pretreatment before the above etching means, so as to further optimize the structure shape of the second textured surface structure, causing the second textured surface structure to have a better reflectivity range.

In some embodiments, etching the second region further includes the following operation.

Through the combination of one or both types of isotropic etching and the anisotropic etching, micro-etched is performed on the surface of the second textured surface structure. By further performing micro-etched on the surface of the second textured surface structure, the surface roughness of the second textured surface structure can be enhanced, thereby improving the utilization of the incident light.

In some embodiments, process parameters for micro-etched include: a temperature being 30 °C~85 °C, a time being 30 s~300 s, a concentration of an alkaline solution being 0.05 wt%~2.5 wt%, and a concentration of an additive being 0.1 wt%~2 wt%, where an alkaline agent in the alkaline solution includes at least one of sodium hydroxide or potassium hydroxide, and the additive includes at least one of an oxidizing agent or a dispersing agent.

In some embodiments, pretreatment is performed after patterning the doped layer and before etching the portion of doped layer in the second region. Process parameters for the pretreatment include: a temperature being 50 °C~85 °C, a time being 50 s~800 s, a concentration of an alkaline solution being 0.05 wt%~2.5 wt%, a concentration of an additive being 0 wt%~2 wt%, and a concentration of hydrogen peroxide being 0 wt%~10 wt%, where an alkaline agent in the alkaline solution includes at least one of sodium hydroxide or potassium hydroxide, and components in the additive include at least one of an oxidizing agent or a dispersing agent.

After the doped layer is patterned, the pretreatment operation can be further performed on the substrate, so as to clean surfaces of the first region and second region. Through the step, some laser damaged regions, dirty impurities, untreated mask layers left on the surface of the substrate due to the previous patterning can be removed, improving the wettability of the surface of the substrate, thereby facilitating the optimization of an effect of subsequently etching the second region.

It can be understood that, in the embodiments of the present invention, the process parameters of the above treatment manners can be regulated through cooperative operations of the above treatment manners such as isotropic etching, anisotropic etching, micro-etching, and pretreatment, thereby obtaining the reflectivity required for different regions in the embodiments of the present invention. However, the reflectivity required for different regions can also be obtained through conventional methods in the art, and the present invention is not limited thereto.

In some embodiments, before patterning the doped layer, the method further includes performing pretreatment on the substrate, and the pretreatment on the substrate includes:
emitters are formed on a light-receiving surface of the substrate;
a backlight surface of the substrate is etched such that the backlight surface of the substrate is disposed with a first textured surface structure;
the doped layer and the mask layer are formed on the backlight surface of the substrate.
The present invention is further described below with reference to more specific embodiments.

### Embodiment 1

This embodiment provides a solar cell. The solar cell is formed by the method below.

A silicon substrate is textured, and then emitters are formed on a light-receiving surface of the silicon substrate through boron expansion.

A backlight surface of the silicon substrate is etched such that the backlight surface of the silicon substrate is disposed with a first textured surface structure.

A silicon oxide dielectric layer and a phosphorus-doped amorphous silicon layer are sequentially deposited on the backlight surface of the silicon substrate to form a passivated contact structure.

Annealing is performed to convert the phosphorus-doped amorphous silicon layer into a phosphorus-doped polycrystalline silicon layer as a doped layer, and a mask layer is formed on a surface of the doped layer.

The doped layer between the silicon substrate and the mask layer is patterned, and a region of the mask layer and the doped layer is opened by a laser patterning process, so as to form a first region and a second region disposed outside the first region, which are different in pattern.

Plating removal is performed, and then the films in the second region are etched until a second textured surface structure is formed on a surface of the substrate in the second region.

The remaining mask layer is removed to expose the patterned doped layer, and the doped layer includes a first film portion, second film portions, and third film portions.

An aluminum oxide passivation layer is formed on the emitters of the light-receiving surface.

A silicon oxynitride anti-reflection layer is formed on the aluminum oxide passivation layer, and the silicon oxynitride passivation and anti-reflection layer is formed on the patterned doped layer of the backlight surface and on the region of silicon substrate that is not covered by the doped layer.

Grid lines and pads are formed on the silicon oxynitride anti-reflection layer such that busbar electrodes and finger electrodes are disposed on the first film portion, the pads are disposed on the second film portions, auxiliary electrodes are disposed on the third film portions, and in a thickness direction of the substrate, an orthographic projection of the pads on the substrate is contained in an orthographic projection of the second film portions on the substrate.

A ratio of an area S_{A2} of the second region to an area S_{A1} of the first region of the backlight surface of the solar cell, the reflectivity R₁ of the solar cell in the first region of the backlight surface, and the reflectivity R₂ of the solar cell in the second region of the backlight surface are shown in Table 1 below.

Furthermore, the first region of the backlight surface further includes first sub-regions corresponding to the position of the first film portion, and second sub-regions corresponding to positions of the second film portions. Observing the solar cell from a direction of the backlight surface, the solar cell has a color difference in the second sub-regions and the first region.

### Embodiment 2 to Embodiment 7

A difference between these embodiments and Embodiment 1 lies in the ratio of S_{A2} to S_{A1} and the reflectivity, and details are shown in Table 1.

### Comparative example

A difference between this comparative example and Embodiment 1 lies in that, a doped layer is not patterned, while a silicon oxynitride anti-reflection layer is directly formed on a light-receiving surface and structures such as a silicon oxynitride passivation and anti-reflection layer are formed on the backlight surface after a doped polycrystalline silicon layer is formed through annealing.

### Performance test description:

The above solar cell is assembled into a 210N-66-type photovoltaic module: 66-type double-glass photovoltaic module formed by 210 mm×210 mm silicon wafers.

Under standard test conditions, tests for photoelectric conversion efficiency and bifaciality are performed on the solar cells in the above embodiments and comparative example and the assembled photovoltaic module by an IV tester. The cell efficiency refers to a test result for the photoelectric conversion efficiency of the light-receiving surface of the solar cell; a cell bifaciality refers to a ratio of the backlight surface efficiency of the cell to the light-receiving surface efficiency; and a module bifaciality refers to a ratio of the backlight surface efficiency of the photovoltaic module to the light-receiving surface efficiency. Standard test conditions include: a spectrum is AM1.5 (air quality 1.5); irradiance is 1000 W/m²; and a temperature is 25 °C (which is stabilized by a temperature control apparatus).

Test results are shown in Table 1.

**Table 1. Performance test results of embodiments**

| | S_{A2}:S_{A1} | R₁/% | R₂/% | Cell efficiency/% | Cell bifaciality/% | Module bifaciality/% | Module power/W |
|---|---|---|---|---|---|---|---|
| Embodiment 1 | 2:3 | 16.50 | 2.80 | 26.59 | 83.50 | 78.07 | 728.84 |
| Embodiment 2 | 1:1 | 16.50 | 3.00 | 26.66 | 87.50 | 81.81 | 730.76 |
| Embodiment 3 | 3:2 | 14.90 | 3.50 | 26.73 | 91.10 | 85.18 | 732.68 |
| Embodiment 4 | 3:1 | 14.80 | 2.90 | 26.76 | 92.60 | 86.58 | 733.50 |
| Embodiment 5 | 17:3 | 15.90 | 2.50 | 26.77 | 94.50 | 88.36 | 733.77 |
| Embodiment 6 | 9:1 | 16.20 | 2.00 | 26.78 | 95.50 | 89.29 | 734.05 |
| Embodiment 7 | 19:1 | 16.00 | 3.00 | 26.78 | 96.00 | 89.76 | 734.05 |
| Comparative example | 0 | 15.60 | \ | 26.56 | 79.00 | 73.87 | 728.02 |

| | | | | | | | |
|---|---|---|---|---|---|---|---|
| Note: "\" in Table 1 indicates that the parameter does not exist. | | | | | | | |

The above test results in the embodiments and comparative example can indicate that the solar cell of the embodiments of the present invention has a certain improvement effect on the cell efficiency. More importantly, the bifaciality of the solar cell of the embodiments of the present invention is significantly higher than that in the comparative example. After a plurality of solar cells are assembled into the photovoltaic module, the bifaciality and conversion efficiency of the module are also improved. In particular, the solar cell in Embodiment 3~Embodiment 7 and the photovoltaic module thereof have a better cell bifaciality and module bifaciality.

In a conventional power station, the reflectivity of an ordinary sandy soil surface is typically 20%~25%. When a set of photovoltaic modules assembled by the solar cell of the embodiments of the present invention is mounted on such soil surface conditions, a power generation capability can be increased by about 0.14% for every 2% increase in bifaciality. For example, comparing the comparative example with the embodiment 1, it can be learned that the module bifaciality in embodiment 1 is significantly increased, thereby facilitating the increasing of the power generation capability. Comparing embodiment 1 with embodiment 7, in some embodiments, the improvement in the module bifaciality is more significant, thereby further increasing the power generation capability. It can be understood that, a large number of photovoltaic modules are used in one power station, and the power generation capability of one set of photovoltaic modules is increased by at least about 0.14%, such that a more significant gain effect on the increasing of the power generation capability is achieved by a large number of the photovoltaic modules, thereby significantly improving the conversion efficiency of the power station, and reducing the power generation cost of the power station.

The technical solutions disclosed in the embodiments of the present invention are described in detail above. Detailed examples are used in this specification to describe the principles and implementations of the present invention. The description of the above embodiments is merely used to facilitate understanding of the technical solutions core invention points of the embodiments of the present invention. Moreover, for those of ordinary skill in the art, according to the idea of the present invention, there will be changes in the specific implementations and the scope of the present invention. In summary, the content of this specification should not be construed as a limitation of the present invention.

## Claims

1. A solar cell, comprising:
a substrate (100);
a doped layer (200) which is patterned, disposed on a backlight surface of the substrate (100);
grid lines (300), disposed on a side of the doped layer (200) away from the substrate (100), wherein the grid lines (300) comprise busbar electrodes (310) and finger electrodes (320), which are intersected with each other, as well as auxiliary electrodes (330), and the auxiliary electrodes (330) are connected to end portions of the busbar electrodes (310) in a length extending direction in a one-to-one manner; and
pads (400), disposed on the busbar electrodes (310) and at junctions between the busbar electrodes (310) and the auxiliary electrodes (330), wherein
the doped layer (200) comprises a first film portion (210) disposed opposite to the busbar electrodes (310) and the finger electrodes (320) in a thickness direction of the substrate (100); the doped layer (200) further comprises at least one second film portion (220) disposed opposite to the pads (400) in the thickness direction of the substrate (100); and in the thickness direction of the substrate (100), an orthographic projection of the pads (400) on the substrate (100) is contained in a range of an orthographic projection of the at least one second film portion (220) on the substrate (100).

2. The solar cell according to claim 1, wherein a plurality of second film portions (220) are provided, the pads (400) and the plurality of second film portions (220) satisfy at least one of following:
the pads (400) are disposed at intervals, and the pads (400) are disposed corresponding to the plurality of second film portions (220) in a one-to-one manner;
the pads (400) are disposed corresponding to the plurality of second film portions (220) in a one-to-one manner, in any group of a pad (400) and a second film portion (220) correspondingly to each other, an area of the pad (400) is S₁, and an area of the second film portion (220) is S₂, wherein 0.1≤S₁:S₂<1:
or, a spacing between each two adjacent busbar electrodes (310) is greater than a spacing between each two adjacent finger electrodes (320), and busbar electrodes (310) around the pads (400) are disposed opposite to the at least one second film portions (220) in the thickness direction of the substrate (100);
or, the solar cell satisfies at least one of following:
the auxiliary electrodes (330) comprise at least one of a fork-shaped grid line, a wave-shaped grid line, or a cross-shaped grid line;
the doped layer (200) further comprises third film portions disposed opposite to the auxiliary electrodes (330) in the thickness direction of the substrate (100); and in the thickness direction of the substrate (100), an orthographic projection of the auxiliary electrodes (330) on the substrate (100) is contained in an orthographic projection of the third film portions on the substrate (100).

3. The solar cell according to claim 2, wherein the first film portion (210) comprises first sub-portions (211) disposed opposite to the busbar electrodes (310) in the thickness direction of the substrate (100), and second sub-portions (212) disposed opposite to the finger electrodes (320); and
each of the at least one second film portion (220) is disposed between two second sub-portions (212), and at least one edge of each of the at least one second film portion (220) in a length extending direction of each of the first sub-portions (211) is attached to a corresponding second sub-portion (212).

4. The solar cell according to claim 3, wherein each of the at least one second film portion (220) is disposed between two adjacent second sub-portions (212), or
each of the at least one second film portion (220) is disposed between two second sub-portions (212) that are not adjacent to each other, and one or more second sub-portions (212) are disposed between the two second sub-portions (212) that are not adjacent to each other.

5. The solar cell according to claim 2, wherein each of the auxiliary electrodes (330) is the fork-shaped grid line; each of the fork-shaped grid lines comprises a first fork line (331) and a second fork line (332), a length extending direction of the first fork line (331) is intersected with a length extending direction of the second fork line (332); the first fork line (331) and the second fork line(332) are disposed at intervals in a length extending direction of each of the finger electrodes (320) to form an interval region (330a); and
an orthographic projection of the fork-shaped grid lines on the substrate (100) is contained in an orthographic projection of the third film portions on the substrate (100).

6. The solar cell according to claim 5, wherein the third film portions are also disposed opposite to positions of interval regions (330a) in the thickness direction of the substrate (100);
or, the solar cell satisfies at least one of following:
end portions of the busbar electrodes (310) are disposed in interval regions (330a);
some of the finger electrodes (320) are disposed in interval regions (330a).

7. The solar cell according to any one of claims 1 to 6, wherein the backlight surface comprises a first region (1A) and a second region (1B) disposed outside the first region (1A), and the first region (1A) is covered by the doped layer (200).

8. The solar cell according to claim 7, wherein the first region (1A) comprises first sub-regions (1A1) disposed opposite to the first film portion (210) in the thickness direction of the substrate (100), and second sub-regions (1A2) disposed opposite to the at least one second film portion (220) in the thickness direction of the substrate (100); in the thickness direction of the substrate (100), an orthographic projection of the second sub-regions (1A2) overlaps with an orthographic projection of the at least one second film portion (220) on the substrate (100);
or, a reflectivity of the solar cell in the first region (1A) of the backlight surface is R₁, a reflectivity of the solar cell in the second region (1B) of the backlight surface is R₂, and R₁ is different from R₂;
or, on a side of the backlight surface, a first textured surface structure is disposed on a surface of the substrate (100) in the first region (1A), a second textured surface structure is disposed on a surface of the substrate (100) in the second region (1B), and the first textured surface structures and the second textured surface structures are different.

9. The solar cell according to claim 8, wherein in the thickness direction of the substrate (100), an orthographic projection of the first sub-regions (1A1) overlaps with an orthographic projection of the first film portion (210) on the substrate (100), and an orthographic projection of the grid lines (300) on the substrate (100) is contained in the orthographic projection of the first film portion (210) on the substrate (100).

10. The solar cell according to claim 8, wherein the second textured surface structures comprise at least one of protruding structures (110) or recessed structures (120);
or, a recessed depth of a surface of the substrate (100) in the second region (1B) relative to a surface of the substrate (100) in the first region (1A) is h, and 0.1 µm<h<7 µm;
or, the first textured surface structure comprises a plurality of boss structures, and the plurality of boss structures satisfies at least one of following:
the plurality of boss structures are disposed at intervals, or a stacked crossover region exists between the plurality of boss structures;
a side length of a bottom of each of the plurality of boss structures is 0.5 µm~8 µm, a side length of a top of each of the plurality of boss structures is 0.1 µm~5 µm, and a height of each of the plurality of boss structures is 0.1 µm~5 µm;
a shape of a cross section of each of the plurality of boss structures is a rectangle, a rhombus, a trapezoid, or an irregular polygon.

11. The solar cell according to claim 10, wherein the protruding structures (110) satisfies at least one of following:
the protruding structures (110) comprise at least one of upright pyramids, truncated pyramids, or curved protrusions;
a micro-etched structure is disposed on an outer surface of each of the protruding structures (110);
or, the recessed structures (120) comprise at least one of dispersed pits, a pit island comprising a plurality of interconnected pits, or inverted pyramids; and the solar cell satisfies at least one of following:
a depth of each of the recessed structures (120) relative to a portion of the backlight surface in the second region (1B) is 0.2 µm~10.0 µm;
a tilt angle of a side wall (121) of the recessed structure (120) relative to a portion of the backlight surface in the second region (1B) is θ, and 90°<θ<170°;
a maximum distance between any two points on an opening contour of each of the recessed structures (120) is 2 µm~40 µm;
a reflectivity of the solar cell in the second region (1B) of the backlight surface is 0.5%~25.0%.

12. The solar cell according to claim 11, wherein the protruding structures (110) comprise the upright pyramids; the solar cell satisfies at least one of following:
a side length of a base of each of the upright pyramids is 0.2 µm~3.5 µm;
a micro-etched structure is disposed on an outer surface of each of the upright pyramids;
a reflectivity of the solar cell in the second region (1B) of the backlight surface is 0.5%~8.0%, which is less than a reflectivity of the solar cell in the first region (1A) of the backlight surface;
or, the protruding structures (110) comprise the truncated pyramids, and the truncated pyramids comprise at least one of regular truncated pyramids or irregular truncated pyramids; the solar cell satisfies at least one of following:
a side length of a base of each of the truncated pyramids is 0.2 µm~3.5 µm;
a micro-etched structure is disposed on an outer surface of each of the truncated pyramids;
a reflectivity of the solar cell in the second region (1B) of the backlight surface is 0.5%~20%, which is less than a reflectivity of the solar cell in the first region (1A) of the backlight surface;
or, the protruding structures (110) comprise the curved protrusions; the solar cell satisfies at least one of following:
a height of each of the curved protrusions is less than1.5 µm;
a reflectivity of the solar cell in the second region (1B) of the backlight surface is 0.5%~25.0%, which is less than a reflectivity of the solar cell in the first region (1A) of the backlight surface.

13. A method for manufacturing the solar cell according to any one of claims 1 to 12, wherein the method comprises the following steps:
patterning a doped layer (200) disposed between a substrate (100) and a mask layer and to form a first region (1A) and a second region (1B) outside the first region (1A), which are different in pattern;
etching a portion of the doped layer (200) in the second region (1B) until a surface of the substrate (100) in the second region (1B) is exposed;
removing a remaining mask layer to expose a patterned doped layer (200), wherein the patterned doped layer (200) comprises a first film portion (210) and at least one second film portion (220); and
forming grid lines (300) and pads (400) on the patterned doped layer (200) such that busbar electrodes (310) and finger electrodes (320) are disposed on the first film portion (210), the pads (400) are disposed on the at least one second film portion (220), and in a thickness direction of the substrate (100), an orthographic projection of the pads (400) on the substrate (100) is contained in an orthographic projection of the at least one second film portion (220) on the substrate (100).

14. The method according to claim 13, wherein etching the portion of the doped layer (200) in the second region (1B) comprises:
forming a second textured surface structure on a surface of the substrate (100) in the second region (1B) by isotropic etching, anisotropic etching, or a combination of the isotropic etching and anisotropic etching;
or, before patterning the doped layer (200) disposed with the substrate (100) and the mask layer, the method further comprises performing pretreatment on the substrate (100); and performing the pretreatment on the substrate (100) comprises:
forming emitters on a light-receiving surface of the substrate (100);
etching a backlight surface of the substrate (100) such that a first textured surface structure is formed on the backlight surface of the substrate (100); and
forming the doped layer (200) and the mask layer on the backlight surface of the substrate (100).

15. A photovoltaic module, comprising a solar cell according to any one of claims 1 to 12, or a solar cell manufactured by the method according to claims 13 or 14.
